**Europäisches Patentamt**

**European Patent Office**

**Office européen des brevets**

(11) Publication number : **0 520 760 A1**

# (12) EUROPEAN PATENT APPLICATION

(21) Application number : **92305790.5**

(22) Date of filing : **24.06.92**

(51) Int. Cl.$^5$ : **G03F 7/00,** G03F 7/12, C25D 1/08

(30) Priority : **24.06.91 JP 151559/91**

(43) Date of publication of application :
**30.12.92 Bulletin 92/53**

(84) Designated Contracting States :
**DE FR GB NL**

(71) Applicant : **BROTHER KOGYO KABUSHIKI KAISHA**
**15-1, Naeshiro-cho, Mizuho-ku**
**Nagoya-shi, Aichi-ken (JP)**

(72) Inventor : **Ohashi, Yumiko, c/o Brother Kogyo K. K.**
**No. 15-1, Naeshiro-cho, Mizuho-ku**
**Nagoya-shi, Aichi-ken (JP)**
Inventor : **Maruyama, Hideo, c/o Brother Kogyo K. K.**
**No. 15-1, Naeshiro-cho, Mizuho-ku**
**Nagoya-shi, Aichi-ken (JP)**

(74) Representative : **Senior, Alan Murray**
**J.A. KEMP & CO., 14 South Square Gray's Inn**
**London WC1R 5LX (GB)**

(54) **Method for producing orifice plate.**

(57) To produce numbers of orifice plates each having high quality at low cost, a master plate for electro-chemical molding has a structure in which electrically non-conductive material is embedded in recessed portions of an electrically conductive substrate. The recessed portion provide a pattern corresponding to a pattern of a plurality of orifices. The master plate has an approximately flat surface in which electrically non conductive sections are spacedly arranged in the orifice pattern in the electrically conductive section. The master plate has high mechanical strength because of the surface flatness. Therefore, after formation of electro-chemical molding film, the substrate is not damaged when the molding film is removed from the master plate, which permit the master plate to be repeatedly used. Further, the master plate is chemically stable, and any contamination to the master plate can be effectively cleaned.

FIG. 3(a)

FIG. 3(b)

FIG. 3(c)

FIG. 3(d)

FIG. 3(e)

FIG. 3(f)

FIG. 3(g)

EP 0 520 760 A1

The present invention relates to a method for producing an orifice plate which for example constitutes an ink ejecting portion of an ink jet printer. More particularly, the invention relates to such method capable of producing the orifice plate with high accuracy and high quality and at low cost.

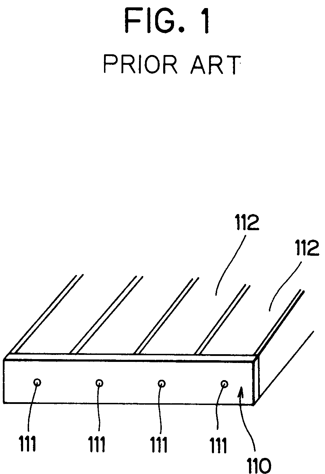

As exemplarily shown in Fig. 1, an ink ejecting portion of an ink jet printer includes an orifice plate 110 formed with a plurality of orifices 111 and a plurality of ink chambers 112 to which the orifice plate is connected. For producing the orifice plate 110, a conventional electro-chemical molding method has been carried out. This method uses a master plate in which an electrically conductive substrate is coated with an electrically non-conductive photoresist and the substrate is subjected to light exposing process and developing process for forming a resist pattern.

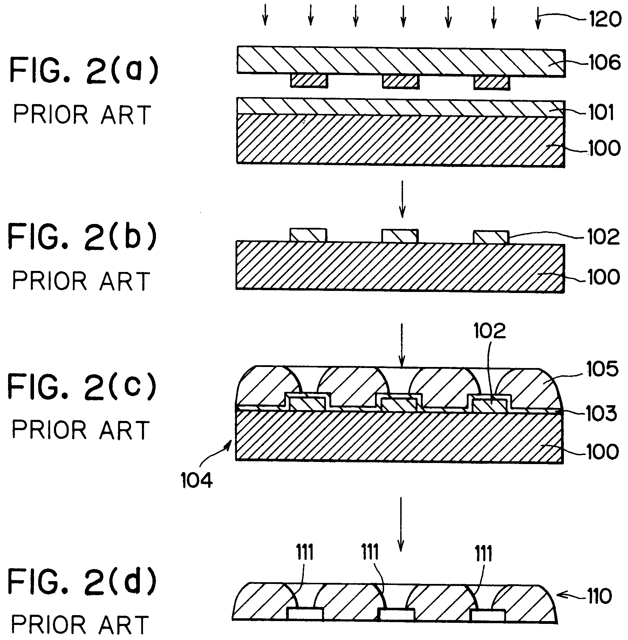

Figs. 2(a) through 2(d) are views for description of each process in the conventional method for producing the orifice plate. The conventional method will hereinafter be described in detail with reference to these drawings.

That is, first, after a photoresist 101 is coated over an electrically conductive substrate 100, ultraviolet rays 120 are irradiated through a photomask 106 as shown in Fig.2(a). Then, after the developing process is performed, baking is conducted for stabilization. Thus, a resist pattern 102 is formed over the electrically conductive substrate 100 as shown in Fig. 2(b). Then, a film 103 of a parting agent is formed over the electrically conductive substrate 100 on which the resist pattern 102 is formed to provide a master plate 104. On the master plate 104, a necessary amount of electro-chemical molding film 105 is provided by an electro-chemical molding method as shown in Fig. 2(c). Thereafter, the electro-chemical molding film 105 is peeled off from the master plate 104 to provide an orifice plate 110 formed with a plurality of orifices 111 as shown in Fig. 2(d).

However, according to the conventional method, bonding strength of the resist pattern 102 relative to the substrate 100 is insufficient, and the resist pattern 102 itself is relatively soft. Therefore, when peeling off the electro-chemical molding film 105 from the master plate 104, the resist pattern 102 is partly removed from the master plate 104 and is involved in the electro-chemical molding film 105. Accordingly, the resist pattern 102 on the master plate is damaged. Consequently, produced orifice plate does not provide desirable quality.

Further, since the photoresist which provide the resist pattern 102 can be dissolved in an organic solvent or alkali solution, it would be impossible to effectively perform electrolytic cleaning within the organic solvent or the alkali solution in case of contamination of the master plate 104. Therefore, the master plate 104 cannot be repeatedly used, which in turn increases the production cost.

The present invention attempts to overcome the above described drawbacks, and it is an object of the invention to provide a method for producing an orifice plate having high quality at low cost.

Thus, according to the present invention there is provided a method for producing an orifice plate formed with a plurality of orifices comprising the steps of (a) forming a photoresist pattern on an electrically conductive substrate, (b) etching the electrically conductive substrate at portions other than superposing portions with the resist pattern for forming a plurality of recessed portions on the electrically conductive substrate, the recessed portions providing a pattern corresponding to a pattern of the plurality of orifices, (c) removing the photoresist from a surface of the electrically conductive substrate, (d) forming an electrically non conductive film sections on the recessed portions to provide a master plate whose surface is substantially flat wherein electrically non conductive sections are spacedly arranged in an electrically conductive section, and (e) electro-chemically molding an orifice plate material on the substantially flat surface of the master plate for forming the orifice plate.

In the method for producing the orifice plate according to this invention, after the resist pattern is formed on the electrically conductive substrate, the electrically conductive substrate is subjected to etching for providing the recessed portions, and the photoresist which defines the resist pattern is removed. Thereafter, the master plate having a flat surface can be provided by forming an electrically non-conductive film on the recessed portions to serve as the master plate for the electro-chemical molding. If electro-chemical molding is carried out with using such master plate, electro-chemical molding film are formed at exclusive positions where sufficiently electrical conductivity is provided. After the films have predetermined thickness, the films are removed from the master plate. Thus, according to the present invention, since is used, for the electro- chemical molding, the master plate in which the recessed patterns are embedded for providing the flat surface, it is possible to prevent a part of the pattern from being robbed by the electro-chemical molding film, when the latter is to be peeled off from the master plate, and repeated use of the master plate is achievable since the master plate can undergo cleaning with the organic solvent or alkali solution. Thus, high moldability is obtainable for providing high quality orifice plate at low cost.

The invention will be further described by way of example with reference to the drawings in which:

Fig. 1 is a perspective view showing schematic arrangement of a conventional ink ejecting portion of an ink jet printer;

Figs 2(a) through 2(d) are views for description of each process according to a conventional method for producing an orifice plate;

Figs 3(a) through 3(g) are views for description of each process according to one embodiment of this invention; and

Fig. 4(a) through 4(h) are views for description of each process according to another embodiment of this invention.

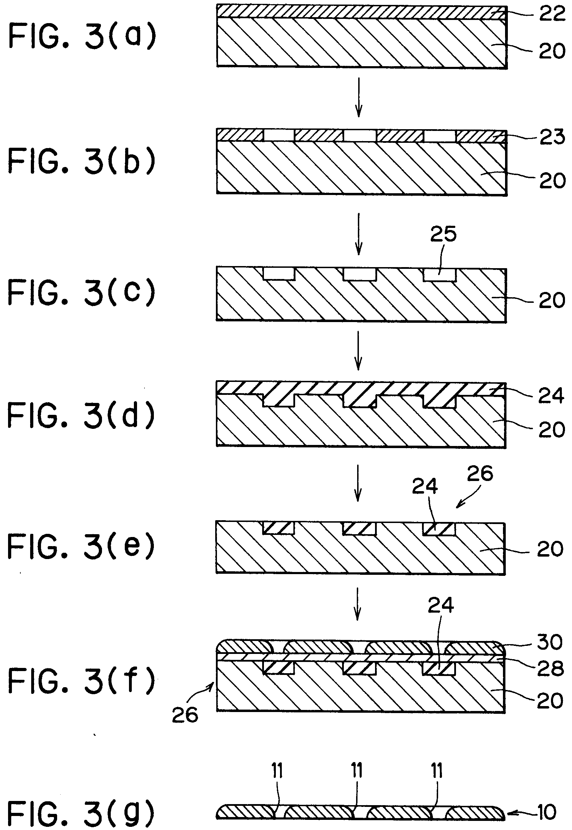

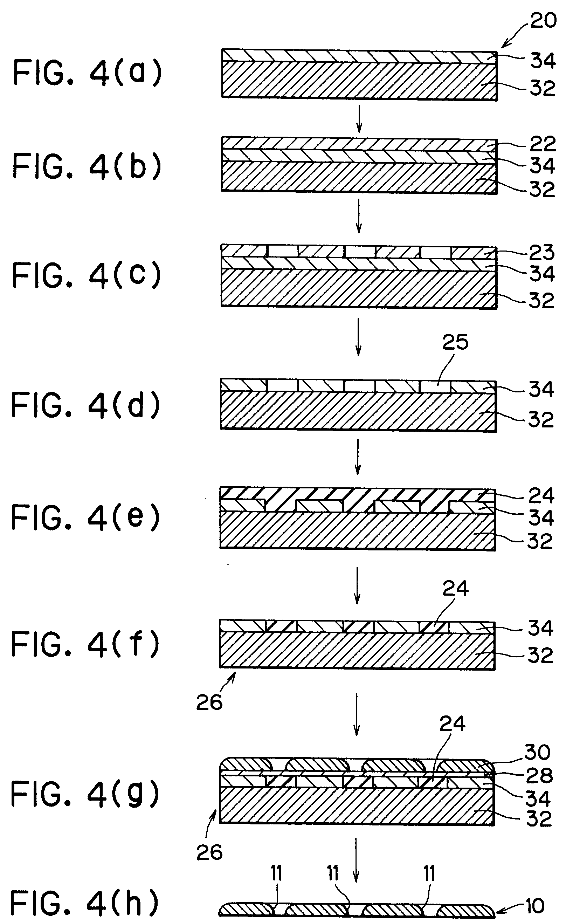

A method for producing an orifice plate according to a first embodiment of this invention will next be described with reference to Figs. 3(a) through 3(g).

According to the depicted embodiment, firstly, as shown in Fig. 3(a), a photoresist 22 is coated on an electrically conductive substrate 20 formed of Ni. Si wafer substrate and stainless steel substrate are also available as the electrically conductive substrate 20. Next, a resist pattern 23 is formed as shown in Fig. 3(b) with a conventional photo-lithographic technique The resist pattern 23 corresponds to the pattern of a plurality of orifices 11 of an orifice plate 10 (see Fig. 3(g)).

Thereafter, exposed portions of the substrate 20 is subjected to etching to the depth of 1000 angstroms by a wet-etching process which employs ferric chloride. Then, the resist pattern is removed by an organic solvent. Therefore, as shown in Fig. 3(c), surface irregularities corresponding to the resist pattern 23 is provided at the surface of the electrically conductive substrate 20. In Fig. 3(c), recessed portions 25 are shown. In the illustrated embodiment, the ferric chloride is used in the wet-etching process. However, conventional dry-etching is also available. Further, the etching depth is normally in a range of from 100 to 50,000 angstroms.

Then, a solution for solgel process is coated on the surface irregular portions of the electrically conductive substrate 20, and then, baking is performed to provide an electrically non-conductive film 24. As the solution for solgel process, are available "OCD" (trade name of Tokyo Ohka Kogyo Co.,Ltd.) and "PZT-20" (trade name of High Purity Chemetals Co.,Ltd.). In the illustrated embodiment, $SiO_2$ film is provided as the electrically non-conductive film by using the above described "OCD" . The baking temperature is in a range of from 300 to 1,100°C, and baking period is in a range of from 0.5 to 3 hours. In the illustrated embodiment, $SiO_2$ film having a thickness of several thousand angstroms is formed for embedding the recessed portion by baking at the temperature of 500°C for 1 hour. Incidentally, as a material of the electrically non-conductive film, oxide, nitride and a mixture thereof are available. Instead of coating the solution for solgel process, sputtering and CVD (chemical vapor deposition) method are also available. Thus, the recessed portions 25 on the electrically conductive substrate 20 are embedded with the electrically non-conductive film 24 formed of $SiO_2$ as shown in Fig. 3(d).

Then, the $SiO_2$ film is subjected to etching until the surface of the electrically conductive substrate 20 is exposed by a conventional dry etching method.

Thus, a master plate 26 having approximately flat surface can be provided.

Then, a parting agent layer 28 is formed over the master plate 26. The parting agent layer 28 can be uniformly coated over the master plate 26 by using a polymer film such as "Nikkanontack" (trade name of Nihon Kagaku Sangyo Co., Ltd.).

Subsequently, the master plate 26 coated with the parting agent layer 28 is dipped in an electro-chemical molding liquid. If electrical current is applied, an electro-chemical molding film 30 made of nickel is deposited only at positions above the electrically conductive substrate surface. The nickel deposition 30 is provided to have a desired thickness. Here, nickel sulfamate bath and copper sulfate bath are available as the electro-chemical molding liquid.

Then, the electro-chemical molding film 30 is peeled off from the master plate 26 to obtain the orifice plate 10 formed with the plurality of orifices 11 shown in Fig. 3(g). In this case, since the master plate 26 has the flat surface, the master plate 26 can release the electro-chemical molding film 30 with maintaining an original configuration shown in Fig. 3(e). Thus, the resultant orifice plate 10 can be produced under high molding accuracy and with high quality.

Incidentally, the parting agent layer 28 may be partly damaged at the time of peeling off the depositions 30 from the master plate. Therefore, if the above described process are repeatedly carried out, residual parting agent layer 28 on the master plate 26 is preferably removed, and a new parting agent layer 28 should be formed thereover for the next electro-chemical molding process.

As described above, according to the first embodiment, the recessed portions 25 are formed in the master plate 26 and the electrically non-conductive film 24 made of $SiO_2$ are formed in the recessed portion 25 for embedding purpose so as to form the orifices 11. Therefore, the master plate 26 has approximately flat surface. As a result, the pattern covered with the $SiO_2$ can be protected from damage. Further, during processing, even if the master plate 26 is contaminated, the master plate 26 can be subjected to cleaning through electrolytic cleaning within alkali solution having high cleaning power or through organic solvent, since high bonding strength is provided between the electrically conductive substrate 20 and the $SiO_2$ film and since the substrate and the film 24 are not easily dissolved in the alkali solution. Accordingly, resultant orifice plate 10 has a stabilized quality.

Next, another embodiment of the present invention will be described along the processing order with reference to Figs. 4(a) through 4(h).

In the second embodiment, an electrically non conductive plate such as a glass substrate 32 is used on which a metallic film 34 made of Cr is formed as shown in Fig. 4(a) to provide an electrically conductive substrate 20. A Ni film, Ti film, Ta film are also available as the metallic film 34. Further, Al$_2$O$_3$ plate is available as the electrically non conductive plate. The thickness of the metallic film 34 is normally in a range of from 100 to 10,000 angstroms. In this embodiment, the thickness is 1,000 angstroms. For forming the metallic film 34, a conventional sputtering method can be used.

Then, as shown in Fig. 4(b), a photoresist 22 is coated over the metallic film 34, and a resist pattern 23 shown in Fig. 4(c) is provided by a conventional photo lithography method. The resist pattern corresponds to a pattern of a plurality of orifices 11.

Thereafter, The metallic film 34 is subjected to etching until a surface of the glass substrate 32 is exposed by a wet etching method in which is used a mixed solution of cerium ammonium nitrate, hydrous and perchloric acid. Incidentally, a conventional dry etching is also available instead of the wet etching.

After the etching, the resist pattern 23 is removed by the organic solvent. Thus, as shown in Fig. 4(d), a pattern of the metallic film 34 can be formed on the glass substrate 32. Incidentally, in Fig. 4(d), reference numeral 25 designates recessed portions.

Thereafter, an orifice plate 10 is provided in accordance with the method described in the foregoing embodiment.

That is, the solution for solgel process is formed over the glass substrate 32, and then, similar to the foregoing embodiment, an electrically non-conductive film 24 formed of SiO$_2$ and having a thickness of several thousand angstroms is formed. In this manner, as shown in Fig. 4(e), the recessed portions 25 defined by the metallic film 34 such as the Cr film is embedded with the electrically non-conductive film 24 such as the SiO$_2$ film.

Then, the SiO$_2$ film is subjected to etching by a conventional dry etching method until the surface of the metallic film 34 provided by the Cr film is exposed. As a result, as shown in Fig. 4(f), a master plate 26 having an approximately flat surface is obtained.

Next, similar to the first embodiment, a parting agent film 28 is coated over the master plate 26, and the master plate 26 provided with the parting agent film 28 is dipped in the electro-chemical molding liquid. Through application of an electrical current, as shown in Fig. 4(g), an electro-chemical molding film 30 made of a nickel is deposited to have a predetermined thickness. Then, the electro-chemical molding film 30 is peeled off from the master plate 26 to obtain an orifice plate 10 formed with a plurality of orifices 11 as shown in Fig. 4(h). In this embodiment, since the master plate 26 has approximately flat surface, the electro-chemical molding film 30 can be peeled off from the master plate with maintaining an original configuration of the master plate 26 as shown in Fig. 4(f). Consequently, is obtained an orifice plate with high molding accuracy with high quality.

As is apparent from the foregoing description, according to the present invention, since the electro-chemical molding is performed in using the master plate having an approximately flat surface which is obtained by forming recessed portions at the electrically conductive substrate and by forming the electrically non-conductive film only at the recessed portions. Therefore, the pattern of the master plate does not undergo any damage. Further, the master plate can be subjected to electrolytic alkali cleaning for enabling repeated use of the master plate. Thus, can be provided the method for producing the orifice plate, in which high molding accuracy is provided and resultant orifice plate has high quality and can be produced at low cost.

While the invention has been described in detail and with reference to specific embodiments thereof, it would be apparent to those skilled in the art that various changes and modifications may be made therein without departing from the scope of the invention.

## Claims

1. A method for producing an orifice plate (10) formed with a plurality of orifices (11), comprising the steps of:
   forming a photoresist pattern (23) on a surface of an electrically conductive substrate (20);
   etching the electrically conductive substrate (20) at portions other than portions superposed by the resist pattern (23) for forming a plurality of recessed portions (25) in the electrically conductive substrate (20), the recessed portions (25) providing a pattern corresponding to a pattern of the plurality of orifices (11);
   removing the photoresist (22) from the surface of the electrically conductive substrate (20);
   forming electrically non conductive film sections (24) in the recessed portions (25) to provide a master plate (26) whose surface is substantially flat and in which the electrically non conductive sections (24) are spacedly arranged in an electrically conductive section (20); and
   electro-chemically moulding an orifice plate material (30) on the substantially flat surface of the master plate (26) for forming the orifice plate (10).

2. A method for producing an orifice plate (10) according to claim 1, wherein the electrically conductive substrate (20) is prepared by preparing a substrate plate (20) formed exclusively of an electrically conductive material.

3. A method for producing an orifice plate (10) according to claim 1 or 2, wherein the forming step for the electrically non conductive film sections (24) comprises the steps of:

coating an electrically non conductive material (24) over one surface of the substrate plate (20);

uniformly removing the thus coated electrically non conductive material (24) until a top surface of the electrically conductive section (20) which has not undergone etching is exposed whereby the master plate (26) has a substantially flat surface.

4. A method for producing an orifice plate (10) according to claim 1, 2 or 3, wherein the photoresist pattern forming step comprises the steps of

coating a photoresist layer (22) on a surface of the substrate plate (20); and

photo-lithographing the photoresist layer (22) to provide the photoresist pattern (23) corresponding to a pattern of the electrically conductive section (20).

5. A method for producing an orifice plate (10) according to any preceding claim, wherein the etching step comprises the step of providing an etching depth ranging from 100 to 50,000 angstroms.

6. A method for producing an orifice plate according to claim 1, wherein the electrically conductive substrate (20) is prepared by preparing an electrically non conductive plate (32) and then by coating an electrically conductive layer (34) on one surface of the electrically non conductive plate (32), the electrically conductive layer (34) providing the electrically conductive section (34).

7. A method for producing an orifice plate (10) according to claim 6, wherein the forming step for the electrically non conductive film sections (24) comprises the steps of:

coating an electrically non conductive material (24) over one surface of the electrically conductive layer (34);

uniformly removing the thus coated electrically non conductive material until a top surface of the electrically conductive section (34) which has not undergone etching is exposed whereby the master plate has a substantially flat surface.

8. A method for producing an orifice plate according to claim 6 or 7, wherein the photoresist pattern forming step comprises the steps of:

coating a photoresist layer (22) on a surface of the electrically conductive layer (34); and

photo-lithographing the photoresist layer (22) to provide the photoresist pattern (23) corresponding to a pattern of the electrically conductive section (34).

9. A method for producing an orifice plate (10) according to any one of claims 6, 7 and 8, wherein the etching step comprises the step of etching the electrically conductive layer (34) until a top surface of the underlying electrically non conductive plate (32) is exposed.

10. A method for producing an orifice plate according to any one of claims 6, 7, 8 and 9 wherein the electrically non conductive plate (32) comprises a glass plate.

11. A method for producing an orifice plate (10) according to any preceding claim, further comprising the steps of peeling off the orifice plate (10) from the substantially flat surface of the master plate (26).

12. A method for producing an orifice plate (10) according to any preceding claim, further comprising the steps of forming a parting agent layer (28) over the substantially flat surface prior to the electro-chemical moulding step.

13. An ink jet printer including an orifice plate produced using a method according to any preceding claim.

# FIG. 1
## PRIOR ART

FIG. 2(a)
PRIOR ART

120
106
101
100

FIG. 2(b)
PRIOR ART

102
100

FIG. 2(c)
PRIOR ART

102
105
103
100
104

FIG. 2(d)
PRIOR ART

111 111 111
110

FIG. 3(a)

22
20

FIG. 3(b)

23
20

FIG. 3(c)

25
20

FIG. 3(d)

24
20

FIG. 3(e)

24
26
20

FIG. 3(f)

24
30
28
20
26

FIG. 3(g)

11    11    11
10

FIG. 4(a)

FIG. 4(b)

FIG. 4(c)

FIG. 4(d)

FIG. 4(e)

FIG. 4(f)

FIG. 4(g)

FIG. 4(h)

European Patent
Office

**EUROPEAN SEARCH REPORT**

Application Number

EP    92 30 5790

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| Y | EP-A-0 239 811 (HEWLETT PACKARD COMPANY)<br>* claims; figures 1-7 *<br>--- | 1-11,13 | G03F7/00<br>G03F7/12<br>C25D1/08 |
| Y | PATENT ABSTRACTS OF JAPAN<br>vol. 012, no. 116 (M-684)13 April 1988<br>& JP-A-62 242 545 ( RICOH CO LTD ) 23 October 1987<br>* abstract *<br>--- | 1-11,13 | |
| Y | DE-A-1 621 034 (BALCO FILTERTECHNIK GMBH)<br>* claims; figures 1-5 *<br>--- | 1-11,13 | |
| Y | US-A-3 655 529 (FUTTERER)<br>* column 2, line 37 - column 2, line 48; claims; figure 2 *<br>----- | 1-11,13 | |
| | | | **TECHNICAL FIELDS SEARCHED (Int. Cl.5 )** |
| | | | G03F<br>C25D<br>B41J |

The present search report has been drawn up for all claims

| Place of search | Date of completion of the search | Examiner |
|---|---|---|
| THE HAGUE | 10 SEPTEMBER 1992 | D. Hillebrecht |

EPO FORM 1503 03.82 (P0401)